# EUROPEAN PATENT APPLICATION

(11) **EP 2 830 213 A1**
(43) Date of publication of application: **28.01.2015**
(21) Application number: 13306067.3
(22) Date of filing: 23.07.2013
(51) Int. Cl.: H03C 1/46, H03H 9/02, H03B 28/00

(54) **Apparatus, method, and computer program for generating an oscillating signal**

(71) Applicant: ALCATEL LUCENT, 92100 Boulogne-Billancourt (FR)
(72) Inventor: Wiegner, Dirk, 70435 Stuttgart (DE); Markert, Daniel, 70435 Stuttgart (DE); Templ, Wolfgang, 70435 Stuttgart (DE)
(74) Representative: 2SPL Patentanwälte PartG mbB

(57) **Abstract**

Embodiments relate to an apparatus, a method, and a computer program for generating an oscillating signal. The apparatus (10) is operable to generate an oscillating output signal and comprises a first coupling element (12) and a second coupling element (14), which is arranged in the proximity of and interacting with the first coupling element (12). The apparatus (10) further comprises an excitation module (16) operable to excite the first coupling element (12) and a combination module (18) operable to combine an output signal of the second coupling element (14) with a supplementary signal to obtain the oscillating output signal.

## Description

### Technical field

Embodiments of the present invention relates to component of radio frequency circuits, more particularly but not exclusively to amplifiers of radio transmitters.

### Background

This section introduces aspects that may be helpful in facilitating a better understanding of the invention. Accordingly, the statements of this section are to be read in this light and are not to be understood as admissions about what is in the prior art or what is not in the prior art.

Energy efficiency, linearity and flexibility are determining factors and competitive parameters of mobile radio transmitters. Some known transmitter concepts use a disruptive transmitter architecture, which is based on analogue signal creation. For example, arrays of nano-mechanical resonators are used. Some nano-mechanical resonators use reeds or cantilevers, which are designed to oscillate at frequencies, which are, for example, determined by the geometric design, the material, the medium around the respective reed, etc.

Conventional and probably future wireless communication makes use of modulation formats and advanced transmission technologies, which may need high quality signal amplification. For example, transmit signals use high peak-to-average ratios. Especially power amplifiers, which are used for wireless communication, are a contributor to the overall energy consumption in such communication systems. Resonators, such as nano-mechanical resonators, are used in such power amplifiers to compose a transmit signal, where resonators generate component signals for sub-bands or frequency bins, which are combined to compose the overall transmit signal. More details on amplifiers using mechanical resonators can, for example, be found in European Patent Application EP 2 509 217 Al. To some of the concepts used for these amplifiers or transmitters it is also referred to as HARP, as the concept has similarities to the musical harp instrument.

### Summary

Embodiments provide an apparatus, a method and a computer program for composing an oscillating signal. Embodiments are based on the finding that linearity or efficiency improvements of resonators, for example, micro- or nano-mechanical resonators, may be achieved using a supplementary signal, which can be combined with the output of such a resonator. Embodiments may enable a reduction of quiescence currents, which may lead to efficiency degradation when used to achieve high linearity. Embodiments may overcome linearity degradations and achieve high efficiency, with a reduced or even zero quiescence current, where a supplementary signal may be used for combination with an output signal of the resonator. The supplementary signal may also be referred to as combination or complement signal. Embodiments are based on the finding that a resonator or a coupling element can be improved or adjusted using a combination of the output with a supplementary signal, and may then allow for simultaneous high efficiency and linearity operation. For example, embodiments can relate to a HARP transmitter.

In other words, it is a finding that in a HARP resonator, which utilizes coupling elements that face each other, the magnitude of the quiescence current may determine the level of the efficiency of the resonator. Embodiments may provide a resonator with improved linearity when reducing the quiescence current, still allowing for high efficiency at the same time.

It is another finding that the reeds in a HARP resonator or amplifier can be adjusted using signal combination. Embodiments make use of a supplementary signal, which may be combined with the output of a reed or coupling element, and which may then increase the linearity of the amplifier or reed circuit. Some embodiments make use of additional reeds, for example, three or four reeds instead of two reeds, in an appropriate adjustment or geometry, such that a more linear characteristic may be achieved, while still maintaining energy efficiency. Some embodiments may combine a supplementary signal generated by a signal generator, such as, for example, a power supply, with the output of a resonator or coupling element. Using a combination of the output signal of the resonator with the generated supplementary signal may improve the linearity characteristics of the amplifier stage while still maintaining high energy efficiency. In some embodiments the efficiency may even be further improved, e.g. when considering the relation of input and output power of the resonator. In an ideal case, some embodiments may have no quiescence current such that high energy efficiency can be achieved at a high linearity level of an amplifier stage.

Embodiments provide an apparatus operable to generate an oscillating output signal. Such an apparatus may correspond to an amplifier, a resonator, a filter, or a generator, which may be based on a concept utilizing a possibly oscillating, an analog, or a digital input signal. The output signal may be composed of one or more frequency components, which are based on or correspond to frequency components in the input signal. In some embodiments oscillations may occur at radio frequencies. For example, the oscillating output signal may be a transmit signal of a wireless communication system. Frequencies of the oscillating output signal may therefore lie in a wide range, for example, starting at 100MHz and ranging up to 5GHz or even higher, a subset thereof, respectively. Moreover, the bandwidth of the output signal may vary accordingly, depending on the bandwidth of the respective system.

Embodiments of the apparatus may therefore be operated by a wireless transceiver, such as a mobile transceiver or a base station transceiver of a mobile communication system. The mobile communication system may, for example, correspond to one of the mobile communication systems standardized by the 3^{rd} Generation Partnership Project (3GPP), e.g. Global System for Mobile Communications (GSM), Enhanced Data rates for GSM Evolution (EDGE), GSM EDGE Radio Access Network (GERAN), High Speed Packet Access (HSPA), Universal Terrestrial Radio Access Network (UTRAN) or Evolved UTRAN (E-UTRAN), Long Term Evolution (LTE) or LTE-Advanced (LTE-A), or mobile communication systems with different standards, e.g. Worldwide Interoperability for Microwave Access (WIMAX) IEEE 802.16 or Wireless Local Area Network (WLAN) IEEE 802.11, generally any system based on Time Division Multiple Access (TDMA), Frequency Division Multiple Access (FDMA), Orthogonal Frequency Division Multiple Access (OFDMA), Code Division Multiple Access (CDMA), etc. In the following the terms mobile communication system and mobile communication network are used synonymously.

The apparatus comprises a first coupling element and a second coupling element. The first coupling element may correspond to an input coupling element and the second coupling element may correspond to an output coupling element. These coupling elements can correspond to micro-mechanical or nano-mechanical devices. For example, the coupling elements may correspond to reeds of a reed resonator. Such a resonator may exploit the mechanical self-resonance of the micro- or nano-sized coupling elements. The mechanical resonance frequencies of these coupling elements can be influenced by their size, their material, their shape, the medium they resonate in, etc. The oscillating signal may be composed of output signals of one or more of these resonators. Moreover, the output of such a resonator may be used to modulate an externally applied signal. Hence, such a resonator may also be used for mixing or converting between different bands, such as frequency up conversion from a baseband to a transmission band. In some embodiments the resonator may redundantize or replace a Digital-to-Analog converter (D/A). That is to say, in some embodiments the apparatus may participate in the processing chain of a wireless transmitter and it may carry out, replace, or redundantize at least one processing step of D/A conversion, mixing, modulating, and amplifying.

In the apparatus the first coupling element and the second coupling element are arranged in proximity of each other. That is to say that the coupling elements are arranged in a way that allows interaction, e.g. electric or magnetic coupling, between the first in the second coupling element. The term interaction is to be understood that there can be an electric or magnetic coupling between these coupling elements. In other words, movements or resonance in the first coupling element may generate a signal at the second coupling element. For example, the coupling elements may correspond to reeds, the tips of which are arranged facing each other. For example, if the tip of the first coupling element approaches the tip of the second coupling element below a certain threshold distance, depending on physical setup field emission may cause current flow between both tips.

The apparatus further comprises an excitation module, which is operable to excite the first coupling element. In other words, the excitation module may apply a signal to the first coupling element, such that the first coupling element is excited, i.e. starts to oscillate. An excitation signal may have different shapes, for example, it may be composed of pulses, such as rectangular pulses, peaks, sign waves or half sine-wave pulses etc. The excitation module is operable to cause the first coupling element to oscillate. The excitation module may correspond to or composed of an excitation device, an excitation unit, a means for exciting, a signal generator, etc. As the first and second coupling elements interact with each other, the mechanical oscillation of the first coupling element is causing a varying output signal at the second coupling element. The apparatus further comprises a combination module, which is operable to combine the output signal of the second coupling element with a supplementary signal to obtain the oscillating output signal. In other words, the oscillating output signal is composed by the combination module based on the output of the second coupling element and the supplementary signal. The combination module may correspond to a combination device, a combination unit, means for combining, a processor, a Digital Signal Processor, etc., and it may, in some embodiments, comprise additional components, such as a signal generator, a power supply, one or more additional coupling elements, etc.

In embodiments, there are different ways of generating the supplementary signal and there are also different ways of how the supplementary signal is combined with the output signal of the second coupling element. In some embodiments at least one of the first and second coupling elements corresponds to a nano-mechanical reed. For example, the first and second coupling elements may correspond to nano-mechanical reeds, which face each other, i.e. they may point towards each other's tips. In some embodiments the combination module can be operable to apply the supplementary signal to the second coupling element to obtain the oscillating output signal. The supplementary signal may then correspond to a phase adjusted voltage signal. For example, in some embodiments the signal evoked at the output of the second coupling element by the first coupling element may correspond to a series of half-sine waves. The combination module may then apply a phase adjusted voltage signal to invert every second of these sine half-waves. A signal with every second sine half-wave inverted may have a better linearity then a series of half-sine waves all having the same polarity. Linearity may correspond to one or more amplifying stages and it may be determined by a narrowness of a bandwidth of the oscillating output signal. In other words, linearity may be better the closer the output oscillating signal matches a perfect sine-wave.

In some embodiments the phase adjusted voltage signal may be a reference voltage, which is applied to the second coupling element and which is superimposed with or modulated by the signal induced or evoked by oscillation of the first coupling element. The phase adjusted voltage signal may then, for example, be used to change the polarity of repetitive parts of the induced or evoked signal to achieve enhanced linearity. Ideally, some embodiments may compose a sinusoidal signal based on a series of half-sine wave shaped pulses induced in the second coupling element, and the phase adjusted voltage signal, which changes the polarity of every second half-sine wave pulse.

In some embodiments the combination module may further comprise a third coupling element being arranged in the proximity of and interacting with one of the first coupling element and the second coupling element. The third coupling element may have different tasks in different embodiments. For example, the third coupling element may be on the excitation side, i.e. it may be excited together with the first coupling element and may hence correspond to another input coupling element. The third coupling element is then arranged in the proximity of the second coupling element, such that an interaction of the third coupling element with the second coupling element is achieved. The excitation module may then excite the first and the third coupling element. The first coupling element may induce or evoke a first signal to the second coupling element and the third coupling element may induce or evoke the supplementary signal to the second coupling element. By using adjusted arrangements between the three coupling elements, a better linearity or a more sinusoidal signal may be achieved at the output of the second coupling element.

In some embodiments the third coupling element is arranged in the proximity of the second coupling element and interacts with the first coupling element. The third coupling element may then correspond to an output coupling element. Hence, if the first coupling element is excited it evokes or induces signals into the second and third coupling elements. The signal output by the third coupling element then corresponds to the supplementary signal, which is combined with the output of the second coupling element by the combination module. The combination module is then operable to combine the output signals of the second and third coupling elements to obtain the oscillating output signal. Similar to what was described above, the arrangement of the two output coupling elements relative to the first or input coupling element may determine the induced or evoked signals.

By using an according symmetry of the two output coupling elements relative to the input element, similar output signals or phase-shifted output signals may be obtained. In some embodiments the combination module can be operable to phase-shift the output signal of at least one of the second and third coupling elements before combining. For example, the second and third coupling elements may be arranged relative to the first coupling elements in a way that a series of half-sine wave shaped pulses is induced in both of the second and the third coupling elements. In some embodiments the output signals may just be superimposed, as the pulses are induced in the second and third coupling elements in alternating polarity and with according time or phase-shifts. In some embodiments the combination module may comprise a balun or a balun transformer to combine the output signals of the second and third coupling elements. The balun or balun transformer may be adapted to the arrangement of the coupling elements in that it may introduce phase-shifts to the one or more output signals of the coupling elements before combining them to the oscillating output signal. The phase-shifts introduced by the balun may be adapted to the geometrical arrangement of the coupling elements, i.e. to the phase-shifts among the induced or evoked signals.

In some embodiments the share or participation to the oscillating output signal of the signals provided by the second and third coupling elements may differ. For example, the output coupling elements may provide pulse signals, which may at least partially follow a periodic signal, e.g. sections of a sinusoidal signal. The sections, e.g. in terms of a section of a period of the periodic signal, may differ among the second third coupling elements. For example, one or both of the output coupling elements may provide more than a half-period of the harmonic signal and the combination module may be operable to overlap these partial signals to obtain the oscillating output signal. In some embodiments signal contributions in an overlapping section may compensate each other, e.g. due accordingly adapted phase shifts of these signals, which can be applied by the combination module, which may be due to the geometry of the second and third coupling elements relative to the first coupling element, or which may be due to the orientation or polarity of the second and third coupling elements relative to each other.

In embodiments the coupling elements can be operable to interact with each other in that current or voltage signals are induced in one coupling element when the other coupling element, which is located in the proximity, oscillates. For example, depending on a phase of a mechanical oscillation of the first coupling element a current is induced in the second coupling element. In further embodiments the apparatus may comprise a first plurality of coupling elements and the excitation module can be operable to excite the first plurality of coupling elements. In embodiments, a higher number of coupling elements may be used to achieve a higher output power, i.e. in terms of the amplification of a signal. In some embodiments the more coupling elements are used the higher the output power may be. That is to say in some embodiments the output power can be adjusted by the number of coupling elements, which is utilized on both sides, i.e. on the input and the output side. The excitation module can then be operable to excite the first plurality of coupling elements. Correspondingly, the apparatus may further comprise a second plurality of coupling elements being arranged in the proximity of and interacting with the first plurality of coupling elements. The combination module can then be operable to combine the output signals of the second plurality of coupling elements to obtain the oscillating output signal. In other words in some embodiments the output power of the apparatus may scale with the number of coupling elements or pairs of coupling elements, which are used.

In further embodiments a coupling element may have a direction, which corresponds to a direction of its longest extension or longitudinal axis. For example, the coupling element may correspond to a reed and the reed may have two ends on its longitudinal axis, which may then be considered as the direction of the reed. At least for the first plurality of reeds or the first coupling element, one end may be attached to a housing or common carrier and may connect to the excitation module, while the other end is free to oscillate. The second coupling element or the second plurality of coupling elements may look similar, however as oscillation may or may not be desired for the output coupling elements, it may not have a loose end. The direction of a coupling element may correspond to the direction of its longest extension and its free end, i.e. the end closest to another coupling element on the other side. That is to say that at least one coupling element of the first plurality of coupling elements can be arranged with its longitudinal axis between two longitudinal axes of two coupling elements of the second plurality of coupling elements; or with its direction pointing between two directions of two coupling elements of the second plurality of coupling elements. It is to be noted that the geometrical relation of the axes are considered in non-deflected states of the coupling elements. The at least one coupling element of the first plurality of coupling elements can be arranged equally spaced to the two coupling elements of the second plurality of coupling elements. In other words, the longitudinal direction of one coupling element from the first plurality of coupling elements may lie in between longitudinal directions of coupling elements from the second plurality of coupling elements on the opposite side. The coupling elements of the second plurality of coupling elements may have parallel longitudinal directions.

In some embodiments the excitation module can be operable to excite the first plurality of coupling elements in phase. That is to say that in-phase excitation signals may be applied to the coupling elements of the first plurality of coupling elements. In other embodiments the excitation module can be operable to excite the first plurality of coupling elements with equal phase-shifts between adjacent coupling elements. Such a phase-shift may, for example, correspond to 180°, or, in other words, in some embodiments the excitation module may excite the first plurality of coupling elements with alternating polarizations of adjacent coupling elements.

As the above-described aspects of embodiments show, different output and supplementary signal components on the output side of the apparatus can be achieved in different ways. These signals may be combined accordingly by the combination module and then yield to the oscillating output signal, which may be basically linear compared to a corresponding input signal. One way is through the combination module, which may or may not apply phase-shifts to the output signals of multiple coupling elements. Another possibility is to apply different excitation signals to different input coupling elements in the first plurality of coupling elements. This would correspondingly induce or evoke phase-shifted output signals in the second plurality of coupling elements. In even further embodiments the coupling elements may be installed or arranged with different phase-shifts, i.e. with different polarities. For example, the polarities of the coupling elements within a plurality of coupling elements on either the input or the output side may have the same polarity, or they may have alternating polarities for adjacent coupling elements, as will be detailed subsequently.

In further embodiments the number of coupling elements of the first plurality of coupling elements may differ from a number of coupling elements of the second plurality of coupling elements. For example, there may be one coupling element more in the first plurality than in the second plurality of coupling elements or vice versa. In embodiments the first and second pluralities of coupling elements may comprise equally spaced coupling elements. Having one coupling element more on one side may allow for geometric arrangements, in which the coupling elements of one side are arranged with their directions pointing between directions of two coupling elements of the other side. In further embodiments each coupling element may have a deflection direction, i.e. a direction in which the coupling element deflects after excitation. These directions may be aligned within a plurality of coupling elements or adjacent coupling elements may have opposite or alternating deflection directions on the input, as it has been explained above using the varying polarities of adjacent coupling elements. Furthermore, adjacent coupling elements of the second plurality of coupling elements may have different or opposite polarities. The different polarities of the coupling elements of the second plurality may be achieved using supply voltages with different polarities. In some embodiments, one or more coupling elements on the input side may be static or may not oscillate, while one or more corresponding or interacting coupling elements on the output side may oscillate. Consequently, in some embodiments the coupling elements on the input side, on the output side, or on both sides may have the same or alternating deflection directions or polarities.

In further embodiments the first plurality of coupling elements may be arranged relative to the second plurality of coupling elements such that at least one coupling element of the first plurality is pointed towards a gap between two coupling elements of the second plurality of coupling elements. That is to say different arrangements are conceivable in different embodiments. Some embodiments may have arrangements where one coupling element from the first plurality is directly facing one coupling element of the second plurality. Other embodiments may have shifted arrangements as pointed out above.

Embodiments further provide a method for generating an oscillating output signal. The method comprises exciting a first coupling element and combining an output signal of a second coupling element, which is arranged in the proximity of and interacting with the first coupling element, with the supplementary signal to obtain the oscillating output signal.

Embodiments further provide a computer program having a program code for performing one of the above methods, when the computer program is executed on a computer, processor, or programmable hardware component. For example, a computer program may control the excitation module and/or the combination module. The excitation module may control or excite multiple input coupling elements or multiple resonators, each potentially comprising multiple input coupling elements. Hence, it is conceivable, at least for some embodiments, to have a method in terms of a computer program, which controls excitation and combination modules based on a wanted and/or on the actual oscillating output signal, for example, based on its linearity, its quality, its power, etc.

Embodiments may provide the advantage that an efficiency-linearity trade-off may be overcome by using the supplementary signal. In other words embodiments may provide an amplifier or a filter with the above apparatus, as for example in the HARP concept, with improved linearity and efficiency.

### Brief description of the Figures

Some other Figs. or aspects will be described using the following non-limiting embodiments of apparatuses and/or methods and/or computer programs and/or computer program products by way of example only, and with reference to the accompanying Figs., in which
Fig. 1 shows an embodiment of an apparatus operable to generate an oscillating output signal;
Fig. 2 illustrates an embodiment with two nano-mechanical reeds;
Fig. 3 illustrates two embodiments in which the supplementary signal is based on a supply voltage or a third coupling element;
Fig. 4 illustrates two embodiments with two input and two output coupling elements and different phase relations of the input or the output signals;
Fig. 5 illustrates an embodiment with three input coupling elements and two output coupling elements;
Fig. 6 illustrates two embodiments with a plurality of coupling elements at the input and a plurality of coupling elements at the output with different alignments; and
Fig. 7 illustrates a block diagram of a flowchart of an embodiment of a method for generating an oscillating output signal.

### Description of embodiments

Various example embodiments will now be described more fully with reference to the accompanying drawings in which some example embodiments are illustrated. In the Figs., the thicknesses of lines, layers and/or regions may be exaggerated for clarity.

Accordingly, while example embodiments are capable of various modifications and alternative forms, embodiments thereof are shown by way of example in the Figs. and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the Figs.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

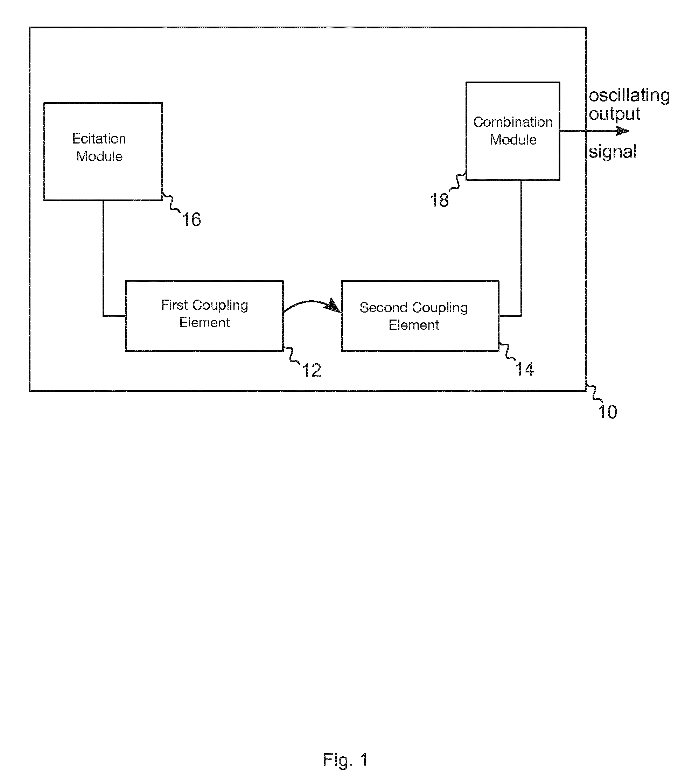

Fig. 1 illustrates an apparatus 10, which is operable to generate an oscillating output signal. For example, the output signal corresponds to an amplified radio frequency signal. The apparatus 10 comprises a first coupling element 12 and a second coupling element 14. The second coupling element 14 is arranged in the proximity of the first coupling element 12 and it interacts with the first coupling element 12 as indicated by the arrow between the first coupling element 12 and the second coupling element 14. The apparatus 10 further comprises an excitation module 16, which is operable to excite the first coupling element 12. As Fig. 1 shows, the excitation module 16 is coupled to the first coupling element 12. The apparatus 10 further comprises a combination module 18, which is coupled to the second coupling element 14. The combination module 18 is operable to combine an output signal of the second coupling element 14 with a supplementary signal to obtain the oscillating output signal. In the following embodiments the first coupling element 12 is operable to interact with the second coupling element 14 if the first coupling element 12 oscillates mechanically.

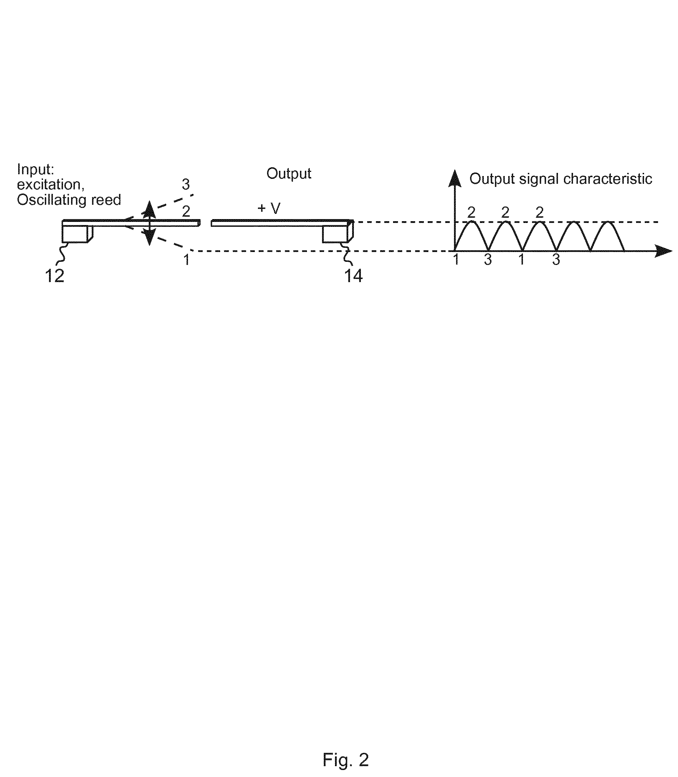

In the following embodiments it is assumed that the first and the second coupling elements 12 and 14 correspond to nano-mechanical reeds. The nano-sized coupling elements, at least on the input side, are mechanical oscillators, where in the following Figs. the oscillation is indicated by arrows pointing up and down relative to the respective coupling element. Such an embodiment is illustrated in Fig. 2. The first coupling element 12 corresponds to an oscillating reed, where Fig. 2 distinguishes three states in the oscillation of the first coupling element 12. The nano-sized reed may oscillate in a vertical direction as shown in Fig. 2. The maximum amplitude towards the bottom is referenced by state "1" and the deflection of reed 12 is indicated by the dotted line underneath the reed 12 in Fig. 2. The neutral state of the input reed 12 is indicated by state "2", i.e. this is assumed to be the state in which reed 12 is not excited. State "2" further corresponds to a transient side when the reed 12 is oscillating and in this state a maximum current may be invoked in the second coupling element 14. The upmost state is referenced with state "3" and the corresponding deflection of reed 12 is also indicated with a dotted line in Fig. 2.

Fig. 2 further shows the second coupling element 14, which also corresponds to a nano-sized reed. In Fig. 2 the second coupling element 14 has the same dimensions as the first coupling element 12. It is to be noted that this is only an example and in other embodiments the shapes of the two coupling elements 12 and 14 may differ from each other. For example, the second coupling element 14 may not oscillate. Therefore, it may have a different length, i.e. a different left-to-right extension than shown in Fig. 2. When excited, the first coupling element 12 oscillates at its resonance frequency and interacts with the second coupling element 14. During the oscillation, where the second coupling element 14 is assumed to be static, the coupling or also the distance between the two tips of the two coupling elements 12 and 14 changes. A supply voltage is applied to the second coupling element 14, which is denoted as +V in Fig. 2, and which can then be modulated through the coupled oscillation from the first coupling element 12. That is to say that in embodiments the supply voltage may be applied between coupling elements of the input side 12 and coupling elements on the output side 14. In the embodiment of Fig. 2, the voltage potential of the second coupling element 14 lies +V above the voltage potential of the first coupling element 12. Similar relations apply to the supply voltages considered in the subsequent embodiments and in the respective Figs. In some embodiments the modulation of the supply voltage may redundantize or replace a frequency up-conversion in a processing chain for a transmitter. Embodiments of the apparatus may also redundantize or replace a digital-to-analog converter, as a digital excitation signal applied to the input reed 12 may result in an analog output signal. The resonance frequency of the first coupling element 12 depends, for example, on its physical properties, i.e. its dimensions, material, temperature, and the medium surrounding it.

It is to be noted that in the following Figs. and embodiments pairs of reeds are assumed as coupling elements 12 and 14. In further embodiments the coupling elements may have other implementations such as vibrating membranes or torsion oscillators of bar elements, disk resonators, etc. The elements themselves may, for example, have piezoelectric coatings such that a mechanical oscillation would result in an accordingly oscillating electric field. In further embodiments other materials are conceivable, for example, magnetic materials generating a magnetic oscillating field along with the mechanical oscillation.

In embodiments a coupling element may be coated with a piezo-active or magnetic material or it may comprise such a material. For example, the base structure of a coupling element may comprise multiple layers or coatings, one of which may support electron emission and another one may be a piezo-active layer. For example, the layer supporting electron emission may be connected or coupled to a contact at which the respective excitation signal can be applied or an output signal can be obtained. In some embodiments there may be other layers such as an oxide layer between the emission layer and the piezo-active layer for insulation purposes. Moreover, in some embodiments there may be another insulating layer on top of the piezo-active layer. Furthermore, in some embodiments the top layer of the coupling element may be a metallization.

Coming back to Fig. 2 and the subsequent Figs., the contacts of the respective coupling elements or reeds are on the left- or right-hand side of the structures shown. In other words, the contact of coupling elements 12 is located on the far end from the oscillating end. Fig. 2 further shows the output signal characteristic of the output of the second coupling element 14. The output signal is shown as a current signal, where the current is given on the ordinate and time is shown on the abscissa. The output signal corresponds to the pure output of the second coupling element, and it corresponds to a modulated DC signal. In the signal graph the three states "1", "2", "3" of the first coupling element 12 are shown. As can be seen from the graph, when the first coupling element 12 swings into position "1", there is no or a very low coupling or induced signal at the second coupling element 14. In the present embodiment, the output signal may equal zero at position "1". When the coupling element 12 swings back to the center position "2", the signal induced or evoked in the second coupling element 14 is maximum in the present embodiment, as shown in the output signal characteristic.

Finally, if the first coupling element 12 swings to position "3", i.e. the far end from position "1", the induced or evoked signal in coupling element 12 equals zero again. That is to say that in the present embodiment it is assumed no signal is evoked or induced in the second coupling element 14 when the first coupling element swing to its maximum deflection states "1" and "3". The resulting signal has the shape of a series of half-sine waves. At positions 1 and 3 there are points of non-linearity in the signal, which could cause degradation in the quality of the output signal. Without a supplementary signal, it can be seen from the output signal in Fig. 2 that such a resonator solution may suffer from the fact that a quiescence current, which would reduce the energy efficiency, would be necessary to achieve a higher linearity. Embodiments may at least partly overcome the trade-off of a reduction in linearity if no quiescence current is applied using a supplementary signal. In other words, Fig. 2 shows two reeds 12 and 14, where the left reed 12 is oscillating. No quiescence current is applied so there may be a high energy efficiency. As indicated on the right-hand side at reed 14, a transmission of half-sine shaped signal parts can be achieved. As it has been mentioned above, instead of the nano-sized reeds mechanical micro systems (MEMS) oscillators may as well be used.

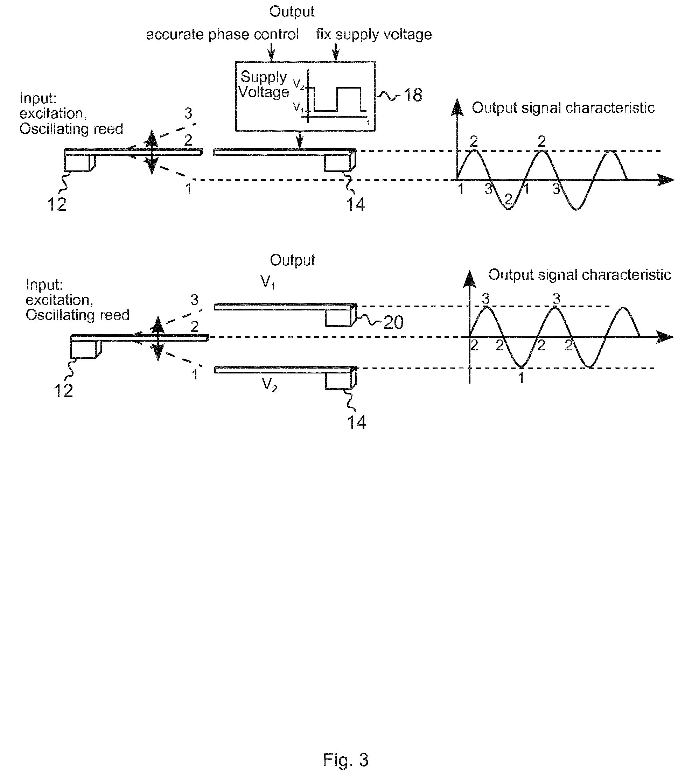

In the following embodiments it will be described how the efficiency-linearity trade-off issue may be reduced in embodiments by applying an extended reed adjustment. Two sets of embodiments are distinguished. In some embodiments the supplementary signal is generated by additional reeds, in other embodiments the supplementary signal is generated by a signal generator, e.g. a voltage signal generator. In the following different kinds of embodiments with different arrangement or combining concepts will be presented. Fig. 3 depicts two embodiments, both of which may achieve an improved linearity of the output signal. In the following embodiments reeds are used as first coupling elements 12 and the first coupling elements 12 are always shown on the left-hand side of the Figs. The second coupling element 14 is also a reed, which is always shown on the right-hand side of the Figs. The reeds shown on the left-hand side are excited by the excitation module 16 as shown in Fig. 1, which is however not shown in the subsequent Figs. to provide a better overview. It is assumed that the excitation module 16 excites the reeds 12 on the respective left-hand sides of the Figs.

The reeds 12 on the left-hand side are inputs, which are coupled to the excitation signal and which react with mechanical oscillation as response to the excitation. The output reeds 14 are supplied with respective supply voltages, which are then modulated and the overall output oscillating signal is shown on the very right-hand side of the respective Figs. Moreover, the Figs. further illustrate the respective states of the input coupling elements 12 within the output signal characteristics. The top embodiment shown in Fig. 3 further illustrates the combination module 18, which comprises a supply voltage 18 in the embodiment shown at the top of Fig. 3. A third coupling element 20 is used to generate the supplementary signal in the embodiment shown at the bottom of Fig. 3 and hence the supply voltage for generating the supplementary signal may be omitted.

In the embodiment shown at the top of Fig. 3 the combination module 18 is operable to apply the supplementary signal to the second coupling element 14 to obtain the oscillating output signal. The supplementary signal corresponds to a phase adjusted voltage signal. In the embodiment the phase adjusted supply voltage corresponds to a rectangular shaped voltage, which is modulated by the signal evoked or induced by the oscillating first coupling element 12. As can be seen from the output signal during the first cycle a positive half-sine wave results in the output signal. During the next oscillation cycle the rectangular supply voltage changes the polarity and hence negative voltages get modulated by the first coupling element 12. As shown in the corresponding output signal this results in a negative half-sine wave, which complements the first positive half-sine wave to the sinusoidal signal shown on the right. The output reed 14 is supplied with the respective supply voltage, and the numbers "1", "2" and "3" characterize deflection states of the input reeds 12. "1" indicates the maximum downward deflection, "2" indicates no deflection, and "3" indicates the maximum upward deflection. The interaction or coupling of the reeds 12 and 14 is based on field emission caused by current flow without mechanical contact between in- and output reeds 12, 14. The electrical current may be maximum when a gap between the in- and output reeds 12, 14 is minimal. Hence, in some embodiments the coupling may be adjusted by different spacings between the two reeds 12 and 14.

The embodiment shown at the top of Fig. 3 is based on only two reeds 12 and 14 and uses the power supply 18 as combination module to create a full sine wave signal, which may correspond to a high linearity on the output side. The power supply 18 may generate a high frequency, e.g. as high as multiple GHz, rectangular signal, which is properly aligned, i.e. phase adjusted, to the oscillation of the input reed 12. The supply voltage adapter or generator 18 may quickly change between the two levels, i.e. it may provide an essentially rectangular signal changing the polarity of every second output pulse of the output reed 14. The embodiment may use an accurate phase control and a fix supply voltage. In further embodiments the power supply 18 may supply single reeds or array(s) of reeds.

Another embodiment is shown at the bottom of Fig. 3. In this embodiment the combination module 18 further comprises a third coupling element 20, which is arranged in the proximity of and interacting with the first coupling element 12 to obtain the supplementary signal. The combination module 18 is further operable to combine the output signals of the second and third coupling elements 14 and 20 to obtain the oscillating output signal. In order to keep a better overview, the combination module 18 is not shown in the lower embodiment of Fig. 3 and in the following Figs. As the following description will show, in some embodiments the combination module 18 may simply add the two output signals of the second and third reeds 14 and 20.

In the embodiment at the bottom of Fig. 3 instead of using the power supply 18 of the former embodiment a third reed 20 is used on the output side. In some embodiments the third reed 20 may not oscillate at all. The third reed 20 may be similar or equal to the second reed 14. It is to be noted that other embodiments may use a third reed on the input side, where two excited input reeds may generate a combined signal in one output reed. In the embodiment shown at the bottom of Fig. 3 the left oscillating reed 12 is positioned between the two reeds 14 and 20 on the right-hand output side in a way that at the neutral deflection state, i.e. at position "2", no current flows or nor coupling occurs. This is also indicated by the output signal characteristic crossing the zero line in state "2", in which the tip of the input reed 12 points between the tips of the output reeds 14 and 20. As shown in Fig. 3, supply voltages, which can be DC voltages, V₁ and V₂ are applied to the two output reeds 20 and 14. These voltages may essentially be DC voltages. In the two deflected states "1" and "3" current signals are induced or evoked in the two output reeds 20 and 14. However, these signals are evoked or induced in an alternating way, i.e. when a signal is induced in the second coupling element 14, there is no signal induced in the third coupling element 20 and vice versa, which is achieved by the geometry or arrangement among the three reeds. In the present embodiment the upper and lower output reeds 14 and 20 are connected to the respective supply voltages. The geometry relative to the input reed allows adjustment of the output signal characteristic. As shown in Fig. 3 a linear sine-shaped output signal may be created, contributing to a spectral construction of a wanted transmit signal, as, for example, in HARP.

The present embodiment further illustrates that with an according geometry and polarity of the three reeds 12, 14 and 20 no phase-shift may be necessary for the combination of the two output signals of the output reeds 14 and 20 as the signals may be added or directly combined to result in the shown sinusoidal output signal characteristic.

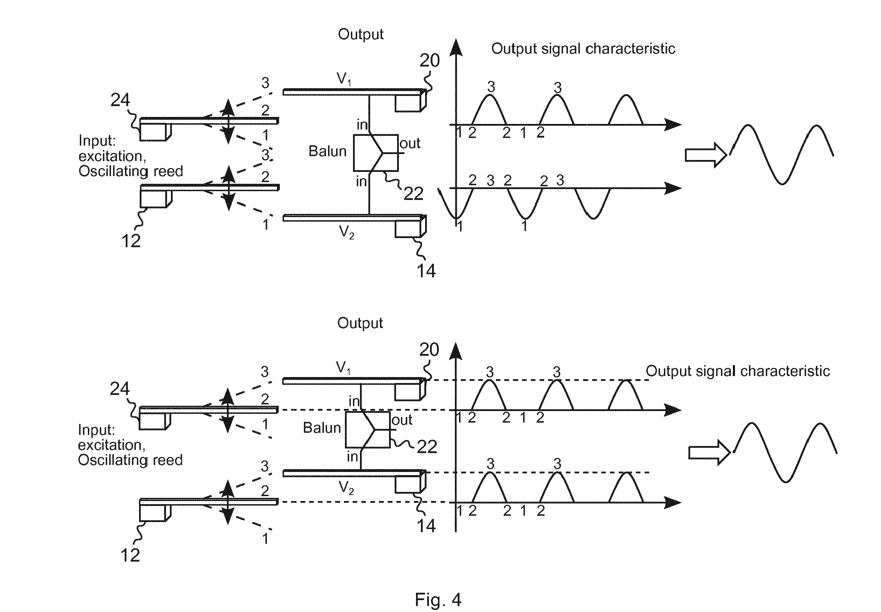

In further embodiments the combination module 18 may be operable to phase-shift the output signal of at least one of the second and third coupling elements 14 and 20 before combining. The actual combining may be carried out using a balun or a transformer. In other words, in some embodiments a combination module 18 may comprise a balun 22 for combining the output signals of the second and third coupling elements 14 and 20 as it is illustrated in the embodiments shown in Fig. 4.

Fig. 4 illustrates two embodiments one at the top and one at the bottom. The two embodiments have in common that on the input side two reeds 12 and 24 are used to interact or couple with two output reeds 14 and 20. Moreover, the embodiments have in common that a balun 22 is used to combine the two output signals of the reeds 20 and 14. Hence, in both embodiments the combination module 18, which is not shown in Fig. 4, comprises the balun 22 and the third reed 20. In other words, the two embodiments shown in Fig. 4 are both based on four reeds 12, 14, 20 and 24, two of which are oscillating and the other two are not oscillating. The two embodiments shown in Fig. 4 differ in the arrangement or relative geometric alignment between the input reeds 12 and 24 and the output reeds 14 and 20. In the embodiment shown at the top of Fig. 4 the two oscillating reeds 12 and 14 are controlled with an in-phase excitation. In the embodiment at the bottom a specific reed adjustment of either 180° phase-shifted excitation or, in case of in-phase excitation, a 180° phase delay when combining the output signals from the output reeds 14 and 20 on the output side, is applied. For signal combining at the output the balun 22 is used in both embodiments. As the output signals indicate, for both embodiments a linear sine-wave signal may be created. In this embodiment it is assumed that the voltage potential V₂ of output reed 14 relative to the input reeds 12 and 24 is negative and the voltage potential V₁ of output reed 20 relative to the input reeds12 and 24 is positive. The upward direction of the view graph showing the corresponding oscillating output signal may therefore be assumed negative.

In other words Fig. 4 illustrates two embodiments wherein the apparatus 10 comprises a first plurality of coupling elements 12 and 24 and wherein the excitation module 16 is operable to excite the first plurality of coupling elements 12 and 24. Furthermore, in both embodiments the apparatus 10 comprises a second plurality of coupling elements 14 and 20 being arranged in the proximity of and interacting with the first plurality of coupling elements 12 and 24. Moreover, the combination module 18 is operable to combine output signals of the second plurality of coupling elements 14 and 20 to obtain the oscillating output signal. As shown by the two embodiments of Fig. 4 depending on the geometrical arrangements, phase-shift control can be applied at the inputs, i.e. by the excitation module 16, or at the output, i.e. by the combination module 18. For example, the excitation module 16 may phase-shift the excitation signal by 180° or the combination module 18 may phase-shift one path of either the output reed 14 or the output reed 20 by 180° before combining, as illustrated by the embodiment at the bottom of Fig. 4. As shown in Fig. 4 in some embodiments the excitation module 16 can be operable to excite the first plurality of coupling elements 12 and 24 in phase. In other embodiments the excitation module 16 can be operable to excite the first plurality of coupling elements 12 and 24 with equal phase-shifts between adjacent coupling elements.

From the above-described embodiments it becomes already clear, that different geometrical arrangements between coupling elements of the input and output sides are conceivable, which may result in different output signals of the individual reeds or different ways of combining these output signals depending on the respective excitations. In some embodiments a direction of a coupling element may correspond to a direction of its longest extension or longitudinal axis. In some embodiments at least one coupling element of the first plurality of coupling elements 12 and 24 can be arranged equally spaced from two coupling elements of the second plurality of coupling elements 14 and 20. The longitudinal axis of an input coupling element may point between two longitudinal axes of two output coupling elements. This is, for example, illustrated in the embodiment shown at the bottom of Fig. 3, where the longitudinal axis of input coupling element 12 lies between the two longitudinal axes of output coupling elements 14 and 20. Moreover, the longitudinal axes of the input and output coupling elements may be parallel. It is to be noted that the geometrical relation of the axis are considered in non-deflected states of the coupling elements.

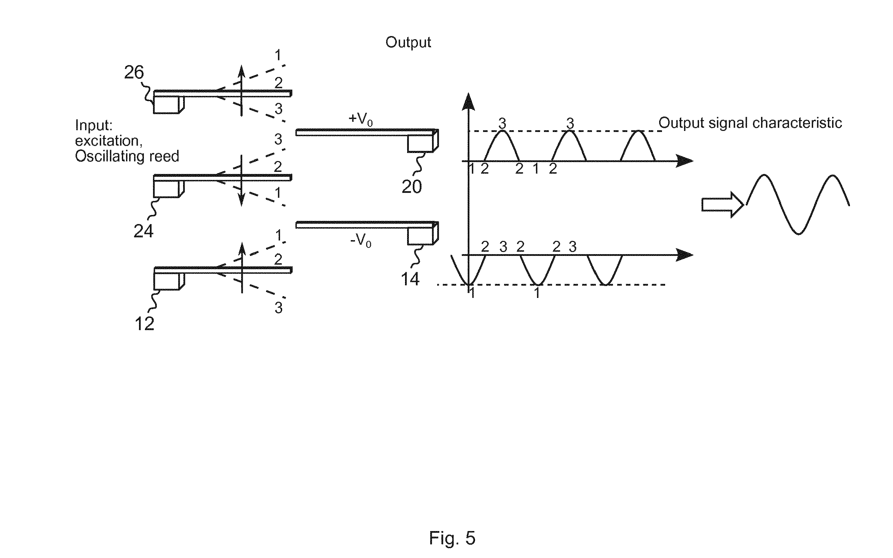

Fig. 5 illustrates yet another embodiment of the apparatus 10, where a first plurality of coupling elements 12, 24 and 26 couples to a second plurality of coupling elements 14 and 20. In the embodiment shown in Fig. 5 the number of coupling elements of the first plurality 12, 24 and 26 of coupling elements differs from the number of coupling elements of the second plurality of coupling elements 14 and 20 by one coupling element, which is also true for the embodiment shown at the bottom of Fig. 3. Moreover, in the embodiment shown in Fig. 5 each of the first and second pluralities coupling elements 12, 14, 20, 24, 26 comprises equally spaced coupling elements. On the input side or in the first plurality of coupling elements 12, 24, 26, each of the coupling elements 12, 24, 26 has a deflection direction and adjacent coupling elements on the input side have opposite deflection directions. The coupling elements of the second plurality of coupling elements 14, 20 have opposite polarities, which are indicated in Fig. 5 by the supply voltages -V₀ for the output coupling element 14 and +V₀ for the output coupling element 20. Neighboring coupling elements on the input side may oscillate with a mutual phase shift of 180°. This is also indicated by the deflection states "1", "2", "3" indicated in Fig. 5 from which it can be seen that the coupling element 24 oscillates with 180° phase-shift when compared to the oscillations of the coupling elements 12 and 26.

It can also be seen from the embodiment shown in Fig. 5 that the first plurality of coupling elements 12, 24, 26 is arranged relative to the second plurality of coupling elements 14, 20 such that at least one coupling element of the first plurality, for example coupling element 24, is pointed towards a gap between the two coupling elements 14, 20 of the second plurality of coupling elements. This can also be seen of the embodiments shown in Figs. 3 and 4. In the embodiments shown in Fig. 5 a linearity and efficiency improvement is achieved by making use of a special alignment of the input reeds 12, 24 and 26 with respect to the output reeds 14 and 20, which are supplied with supply voltages of different polarities as shown in Fig. 5. In the embodiment of Fig. 5 the excitation is the same as in the embodiment shown at the top of Fig. 4 and also the combined output waveforms are similar. The difference between the embodiment shown at the top of Fig. 4 and in Fig. 5 lies in the arrangement of the reeds, where the embodiment at the top of Fig. 4 uses two input reeds 12 and 24 and two output reeds 14 and 20 per transfer path.

Thus, 4xN reeds are used by this embodiment, where N represents a number of transfer paths per frequency to be created. It is to be noted that for example in an HARP amplifier, there may be multiple paths per frequency utilizing several hundreds or thousands of reeds. In contrary, the embodiment shown in Fig. 5 uses 2N+1 reeds 12, 24, 26 for the same number of transfer paths, which is only one more reed than in the embodiment shown at the top of Fig. 2. In some embodiments this can be achieved by having 2N+1 exciting reeds 12, 24, 26 equally spaced along one axis, e.g. normal to the direction of their longest elongation, and the receiving reeds 14, 20 (N elements) are also equally spaced with the same distance and centered to the exciting reeds 12, 24, 26. This is illustrated in the embodiment shown in Fig. 5. Additionally, the deflection direction alternates from one exciting reed to another. In other words, there may be a 180° phase shift between the oscillations of adjacent reeds. For example, every (2n+1)th reed, or every reed with an odd count, is deflected upward for given input pulse, while every 2nth reed, or every reed with an even count, is deflected downward, where 0≤n≤N.

In other words, every second input reed may have a different polarization or orientation. For example, input reeds on odd positions may deflect to the top while input reeds at even positions deflect to the bottom or vice versa. On the receiving side the polarization of neighboring reeds 14, 20 may as well be alternating or the combination may use a balun 22 as shown in Fig. 4. Alternating polarization may be achieved by different orientations of neighboring reeds with respect to their deflection directions. For example, neighboring reeds may deflect in opposite directions when excited with the same excitation signal when mounted with opposing material polarization. In other embodiments phase shifted excitation signals may be used to achieve the same effect for neighboring reeds with their material polarizations oriented in the same direction. Alternatively, and this is illustrated in Fig. 5, different polarizations in the supply voltages can be used. Additionally or alternatively to a change of the deflection direction of adjacent reeds, polarity of the output reed supply voltage may be changed by means of a fast switching. For example, a power supply signal, e.g. of up to multiple GHz, and properly aligned, i.e. phase aligned, from supply voltage adapter may be used. The supply signal may, for example, feature two fixed levels, similar to what was explained above for the embodiment shown at the top of Fig. 3.

As shown by the described embodiments the level of complexity may differ. For some applications the embodiments shown at the bottom of Fig. 3 and in Fig. 5 may have the lowest complexity among the embodiments presented.

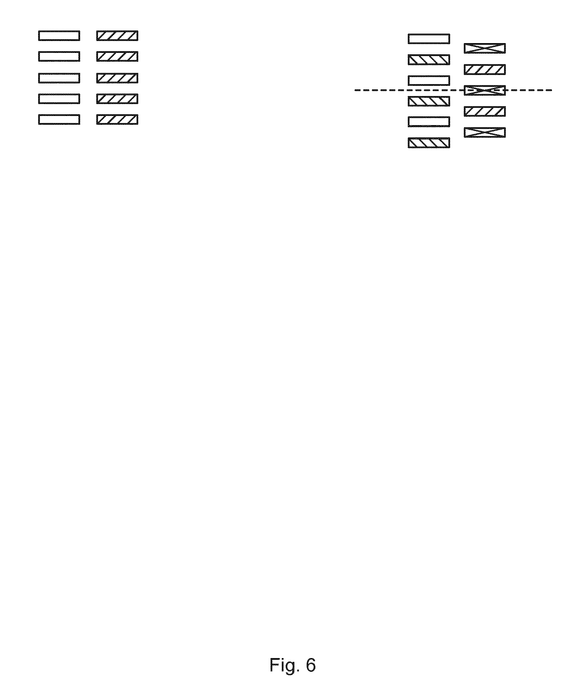

Fig. 6 shows principal orientations of the input coupling elements and the output coupling elements. Fig. 6 shows on the left-hand side an embodiment, which is in line with the embodiment shown at the top of Fig. 3, in which input and output reeds face each other or are oriented in parallel directions. As in the above Figs. the input reeds are shown on the left and the output reeds are shown on the right. On the right-hand side Fig. 6 shows an embodiment with one more input reed than output reeds. On both sides every second reed's polarity is changed indicated by alternating hachures. On the input side the deflection direction of every second reed is changed similar to what was discussed for the embodiments shown in Fig. 5. The centers of the two pluralities of input and output reeds are aligned, yielding the structure shown in Fig. 6 on the right, namely a gap on the input side faces a reed on the output side. On the output side every second reed is changed in polarization, which can be achieved according to the above description, and which is indicated in Fig. 6 by the different hachures.

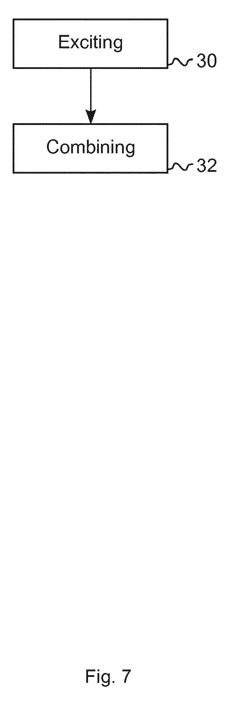

Fig. 7 illustrates a block diagram of a flowchart of an embodiment of a method for generating an oscillating output signal. The method comprises exciting 30 a first coupling element 12 and combining 32 an output signal of the second coupling element 14, which is arranged in the proximity of and interacting with the first coupling element 12, with the supplementary signal to obtain the oscillating output signal.

Embodiments may further provide a computer readable storage medium storing instructions which, when executed by a computer, cause the computer to implement one of the methods described herein. Embodiments further provide a computer program or a computer program product having a program code for performing anyone of the above described methods, when the computer program or computer program product is executed on a processor, computer, or programmable hardware.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions where said instructions perform some or all of the steps of methods described herein. The program storage devices may be, e.g., digital memories, magnetic storage media such as magnetic disks and magnetic tapes, hard drives, or optically readable digital data storage media. The embodiments are also intended to cover computers programmed to perform said steps of methods described herein or (field) programmable logic arrays ((F)PLAs) or (field) programmable gate arrays ((F)PGAs), programmed to perform said steps of the above-described methods.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for ..." (performing a certain function) shall be understood as functional blocks comprising circuitry that is adapted for performing or to perform a certain function, respectively. Hence, a "means for s.th." may as well be understood as a "means being adapted or suited for s.th.". A means being adapted for performing a certain function does, hence, not imply that such means necessarily is performing said function (at a given time instant).

The functions of the various elements shown in the Figs., including any functional blocks labeled as "means", "means for exciting", "means for combining", etc., may be provided through the use of dedicated hardware, such as "an exciter", "a combiner", etc. as well as hardware capable of executing software in association with appropriate software. Moreover, any entity described herein as "means", may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included. Similarly, any switches shown in the Figs. are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

## Claims

1. An apparatus (10) operable to generate an oscillating output signal, the apparatus (10) comprising
a first coupling element (12);
a second coupling element (14) being arranged in the proximity of and interacting with the first coupling element (12);
an excitation module (16) operable to excite the first coupling element (12); and
a combination module (18) operable to combine an output signal of the second coupling element (14) with a supplementary signal to obtain the oscillating output signal.

2. The apparatus (10) of claim 1, wherein at least one of the first and the second coupling elements (12; 14) corresponds to a nano-mechanical reed.

3. The apparatus (10) of claim 1, wherein the combination module (18) is operable to apply the supplementary signal to the second coupling element (14) to obtain the oscillating output signal, wherein the supplementary signal corresponds to a phase adjusted voltage signal.

4. The apparatus (10) of claim 1, wherein the combination module (18) further comprises a third coupling element (20) being arranged in the proximity of and interacting with the first coupling element (12) to obtain the supplementary signal, and wherein the combination module (18) is further operable to combine the output signals of the second and third coupling elements (14; 20) to obtain the oscillating output signal.

5. The apparatus (10) of claim 4, wherein the combination module (18) is operable to phase shift the output signal of at least one of the second and third coupling elements (14; 20) before combining.

6. The apparatus (10) of claim 4, wherein the combination module (18) comprises a balun (22) for combining the output signals of the second and third coupling elements (14; 20).

7. The apparatus (10) of claim 1, wherein the first coupling element (12) is operable to interact with the second coupling element (14) in that depending on a phase of a mechanical oscillation of the first coupling element (12) a current is induced in the second coupling element (14).

8. The apparatus (10) of claim 1, comprising a first plurality of coupling elements (12; 24; 26) and wherein the excitation module (16) is operable to excite the first plurality of coupling elements (12; 24; 26), and further comprising a second plurality of coupling elements (14; 20) being arranged in the proximity of and interacting with the first plurality of coupling elements (12; 24; 26), wherein the combination module (18) is operable to combine output signals of the second plurality of coupling elements (14; 20) to obtain the oscillating output signal.

9. The apparatus (10) of claim 8, wherein a direction of a coupling element (12; 14; 20; 24; 26) corresponds to a direction of its longitudinal axis, and wherein at least one coupling element of the first plurality of coupling elements (12; 24; 26) is arranged with its direction pointing between two directions of two coupling elements of the second plurality of coupling elements (14; 20) and the at least one coupling element of the first plurality of coupling elements (12; 24; 26) is arranged equally spaced from two coupling elements of the second plurality of coupling elements (14; 20).

10. The apparatus (10) of claim 8, wherein the excitation module (16) is operable to excite the first plurality of coupling elements (12; 24; 26) in phase or wherein the excitation module (16) is operable to excite the first plurality of coupling elements (12; 24; 26) with equal phase shifts between adjacent coupling elements.

11. The apparatus (10) of claim 8, wherein a number of coupling elements of the first plurality of coupling elements (12; 24; 26) differs from a number of coupling elements of the second plurality of coupling elements (14; 20) by one coupling element.

12. The apparatus (10) of claim 8, wherein each of the first and second pluralities of coupling elements (12; 14; 20; 24; 26) comprise equally spaced coupling elements, wherein each of the coupling elements of the first plurality (12; 24; 26) has a deflection direction and wherein adjacent coupling elements of the first plurality (12; 24; 26) have opposite deflection directions, and wherein the coupling elements of the second plurality of coupling elements (14; 20) have opposite polarities.

13. The apparatus (10) of claim 12, wherein the first plurality of coupling elements (12; 24; 26) is arranged relative to the second plurality of coupling elements (14; 20) such that at least one coupling element of the first plurality (12; 24; 26) is pointed towards a gap between two coupling elements (14; 20) of the second plurality of coupling elements (14; 20).

14. A method for generating an oscillating output signal, the method comprising
Exciting (30) a first coupling element; and
Combining (32) an output signal of a second coupling element, which is arranged in the proximity of and interacting with the first coupling element, with a supplementary signal to obtain the oscillating output signal.

15. A computer program having a program code for performing the method of claim 14, when the computer program is executed on a computer or processor.

## Amended claims

### Amended claims in accordance with Rule 137(2) EPC.

**1.** An apparatus (10) operable to generate an oscillating output signal, the apparatus (10) comprising
a first coupling element (12);
a second coupling element (14) being arranged in the proximity of and interacting with the first coupling element (12), wherein the first coupling element (12) is operable to interact with the second coupling element (14) in that depending on a phase of a mechanical oscillation of the first coupling element (12) a current is induced in the second coupling element (14);
an excitation module (16) operable to excite the first coupling element (12); and
a combination module (18) operable to combine an output signal of the second coupling element (14) with a supplementary signal to obtain the oscillating output signal, wherein the combination module (18) further comprises
a third coupling element (20) being arranged in the proximity of and interacting with the first coupling element (12) to obtain the supplementary signal, or
wherein the combination module (18) comprises a signal generator operable to generate the supplementary signal,
and wherein the combination module (18) is further operable to combine the output signals of the second and third coupling elements (14; 20) or the output signals of the second coupling element (14) and the signal generator to obtain the oscillating output signal, wherein the combination module (18) comprises a balun (22) for combining the output signals of the second and third coupling elements (14; 20) or the output signals of the second coupling element (14) and the signal generator.

**2.** The apparatus (10) of claim 1, wherein at least one of the first and the second coupling elements (12; 14) corresponds to a nano-mechanical reed.

**3.** The apparatus (10) of claim 1, wherein the combination module (18) is operable to apply the supplementary signal to the second coupling element (14) to obtain the oscillating output signal, wherein the supplementary signal corresponds to a phase adjusted voltage signal compared to a signal evoked by the first coupling element (12) at an output of the second coupling element (14).

**4.** The apparatus (10) of claim 4, wherein the combination module (18) is operable to phase shift the output signal of at least one of the second and third coupling elements (14; 20) before combining.

**5.** The apparatus (10) of claim 1, comprising a first plurality of coupling elements (12; 24; 26) and wherein the excitation module (16) is operable to excite the first plurality of coupling elements (12; 24; 26), and further comprising a second plurality of coupling elements (14; 20) being arranged in the proximity of and interacting with the first plurality of coupling elements (12; 24; 26), wherein the combination module (18) is operable to combine output signals of the second plurality of coupling elements (14; 20) to obtain the oscillating output signal.

**6.** The apparatus (10) of claim 6, wherein a direction of a coupling element (12; 14; 20; 24; 26) corresponds to a direction of its longitudinal axis, and wherein at least one coupling element of the first plurality of coupling elements (12; 24; 26) is arranged pointing between two coupling elements of the second plurality of coupling elements (14; 20) and the at least one coupling element of the first plurality of coupling elements (12; 24; 26) is arranged equally spaced from two coupling elements of the second plurality of coupling elements (14; 20).

**7.** The apparatus (10) of claim 6, wherein the excitation module (16) is operable to excite the first plurality of coupling elements (12; 24; 26) in phase or wherein the excitation module (16) is operable to excite the first plurality of coupling elements (12; 24; 26) with equal phase shifts between adjacent coupling elements.

**8.** The apparatus (10) of claim 6, wherein a number of coupling elements of the first plurality of coupling elements (12; 24; 26) differs from a number of coupling elements of the second plurality of coupling elements (14; 20) by one coupling element.

**9.** The apparatus (10) of claim 6, wherein each of the first and second pluralities of coupling elements (12; 14; 20; 24; 26) comprise equally spaced coupling elements, wherein each of the coupling elements of the first plurality (12; 24; 26) has a deflection direction and wherein adjacent coupling elements of the first plurality (12; 24; 26) have opposite deflection directions, and wherein adjacent coupling elements of the second plurality of coupling elements (14; 20) have opposite polarities.

**10.** The apparatus (10) of claim 10, wherein the first plurality of coupling elements (12; 24; 26) is arranged relative to the second plurality of coupling elements (14; 20) such that at least one coupling element of the first plurality (12; 24; 26) is pointed towards a gap between two coupling elements (14; 20) of the second plurality of coupling elements (14; 20).

**11.** A method for generating an oscillating output signal, the method comprising
Exciting (30) a first coupling element, wherein the first coupling element (12) is operable to interact with a second coupling element (14), which is arranged in the proximity of and interacting with the first coupling element in that depending on a phase of a mechanical oscillation of the first coupling element (12) a current is induced in the second coupling element (14);
using
a third coupling element (20) being arranged in the proximity of and interacting with the first coupling element (12) to obtain a supplementary signal, or
a signal generator operable to generate the supplementary signal;
Combining (32) the output signals of the second and third coupling elements (14; 20) or the output signals of the second coupling element (14) and the signal generator to obtain the oscillating output signal using a balun (22).

**12.** A computer program having a program code for performing the method of claim 11, when the computer program is executed on a computer or processor.
